# EUROPÄISCHE PATENTSCHRIFT

(11) **EP 4 727 302 B1**
(45) Veröffentlichungstag und Bekanntmachung des Hinweises auf die Patenterteilung: **29.07.2026**
(21) Anmeldenummer: 24206334.5
(22) Anmeldetag: 14.10.2024
(51) Int. Cl.: H10F 39/18, H10F 39/00

(54) **BILDSENSORANORDNUNG**
IMAGE SENSOR ARRANGEMENT
ENSEMBLE CAPTEUR D'IMAGE

(43) Veröffentlichungstag der Anmeldung: 15.04.2026
(73) Patentinhaber: SICK AG, 79183 Waldkirch (DE)
(72) Erfinder: Bleicher, Katharina, 79312 Emmendingen (DE); Murhed, Anders, SE582 46 Linköping (SE); Steinkogler, Sascha, 79106 Freiburg (DE)
(74) Vertreter: Manitz Finsterwald Patent- und Rechtsanwaltspartnerschaft mbB

(56) Entgegenhaltungen:
- US-A1- 2007 285 843
- US-A1- 2009 078 872
- US-A1- 2022 078 318
- US-A1- 2023 319 384

## Beschreibung

Die vorliegende Erfindung betrifft eine Bildsensoranordnung mit einem Bildsensor, welcher eine Matrixanordnung von lichtempfindlichen Empfangselementen aufweist, und mit einem dem Bildsensor vorgeordneten Mikrolinsenarray mit einer Matrixanordnung von Mikrolinsen, wobei einem jeweiligen Empfangselement eine jeweilige Mikrolinse zugeordnet ist.

Bildsensoren sind Vorrichtungen zur lichtbasierten Aufnahme von zweidimensionalen Abbildern von Szenen. Sie umfassen eine Matrixanordnung oder ein Array von in Reihen und Spalten angeordneten lichtempfindlichen Empfangselementen, welche erfasste Lichtsignale in entsprechende elektrische Signale umwandeln. Es sind Bildsensoren in unterschiedlichen Bauformen oder Technologien bekannt, beispielsweise CCD-Sensoren, CMOS-Sensoren, Bayer-Sensoren, Active-Pixel-Sensoren (APS) oder Silizium-Photomultiplier (SiPm). Bei vielen Bauformen von Bildsensoren umfasst die lichtempfindliche Fläche eines Empfangselements oder Pixels, d.h. diejenige Fläche, welche effektiv zur Erfassung des auftreffenden Lichts beiträgt, nur einen Teil der Gesamtfläche des Empfangselements. Aus technischen Gründen können bestimmte Bereiche des Empfangselements nicht zur Lichterfassung bzw. -umwandlung genutzt werden, weil sie beispielsweise für Leitungen oder Trennschichten benötigt werden. Das Verhältnis der lichtempfindlichen Fläche zur Gesamtfläche des Empfangselements wird auch als Füllfaktor (Englisch fill factor) bezeichnet.

Ein idealer Bildsensor mit maximal großer lichtempfindlicher Fläche weist einen Füllfaktor von 100% auf. Aufgrund der oben genannten Einschränkungen weisen reale Bildsensoren jedoch Füllfaktoren von 75% oder weniger auf. Da bei realen Bildsensoren ein Teil des innerhalb eines Empfangselements auftreffenden Lichts nicht in entsprechende elektrische Signale umgewandelt wird, reduziert sich die Empfindlichkeit des Bildsensors und führt insbesondere bei schwachen Beleuchtungsbedingungen zu einem erhöhten Bildrauschen.

Dieser Nachteil kann zumindest zu einem großen Teil dadurch kompensiert werden, dass dem Bildsensor ein Mikrolinsenarray vorgeordnet wird. Das Mikrolinsenarray umfasst eine Matrixanordnung von Mikrolinsen, deren Rastermaß im Wesentlichen dem Rastermaß der Matrixanordnung von lichtempfindlichen Empfangselementen des Bildsensors entspricht, so dass jedem Empfangselement eine jeweilige Mikrolinse vorgeordnet ist. Das Rastermaß des Mikrolinsenarrays kann sich geringfügig von dem Rastermaß der Matrixanordnung der Empfangselemente unterscheiden, um hierdurch in Randbereichen des Bildsensors einen lateralen Versatz zwischen den Mikrolinsen und den Empfangselementen zu erzeugen so dass auch schräg auftreffende Teillichtbündel bzw. Hauptstrahlen möglichst vollständig erfasst werden. Die Größe einer jeweiligen Mikrolinse entspricht dabei der Größe des zugeordneten Empfangselements. Dadurch wird zumindest annähernd diejenige Lichtmenge erfasst, die auf eine der Größe des Empfangselements entsprechende Fläche trifft. Die Mikrolinse bündelt das erfasste Licht auf die eigentliche lichtempfindliche Fläche des Empfangselements (z.B. eine im Empfangselement angeordnete Fotodiode), so dass Lichtverluste, die durch ein Auftreffen von Licht auf lichtunempfindliche Bereiche entstehen würden, zumindest weitgehend vermieden werden. Mit derartigen Bildsensoranordnungen können Füllfaktoren von annähernd 100% erzielt werden.

Für eine effektive Bündelung muss das Mikrolinsenarray aus geometrischen Gründen einen bestimmten Abstand zur Oberfläche des Bildsensors aufweisen. Zudem weist der Bildsensor oftmals zusätzliche Strukturen an seiner Oberfläche auf, welche zur Vermeidung von Übersprechen benachbarte Empfangselemente optisch voneinander abschirmen. Diese Abschirmungsschichten oder Trennstege weisen eine bestimmte Höhe auf und definieren somit ebenfalls einen Mindestabstand zwischen dem Mikrolinsenarray und dem Bildsensor.

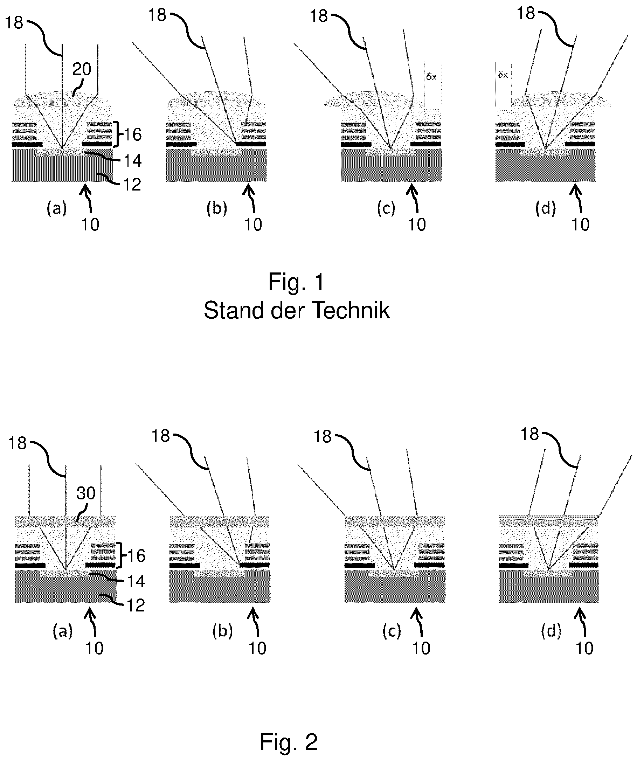

Aufgrund dieser konstruktiven Gegebenheiten werden von derartigen Bildsensoranordnungen nur diejenigen Lichtstrahlen oder Lichtbündel vollständig erfasst, welche einen Hauptstrahlwinkel von 0° aufweisen und somit senkrecht auf die Oberfläche des Bildsensors bzw. der Bildsensoranordnung einfallen, wobei hierfür angenommen wird, dass die Mikrolinsen jeweils zentriert zu den zugehörigen Empfangselementen ausgerichtet sind. Falls das zu erfassende Empfangslicht schräg, d.h. mit einem von 0° verschiedenen Hauptstrahlwinkel auf die Bildsensoranordnung einfällt, ist unter Umständen eine vollständige Erfassung des von den Mikrolinsen fokussierten Lichts nicht mehr gegeben. Diese Problematik wird nachfolgend mit Bezug auf Fig. 1 beschrieben.

Fig. 1a zeigt ein einzelnes lichtempfindliches Empfangselement 10 eines Bildsensors, welches ein Substrat 12, beispielsweise ein Siliziumsubstrat, und eine auf der Oberseite des Substrats 12 angeordnete Fotodiode 14 umfasst, welche die eigentliche lichtempfindliche Fläche des Empfangselements 10 bildet. Die Fotodiode 14 wird von einer Abschirmung 16 umgrenzt, welche beispielsweise aus mehreren leitenden oder auch nichtleitenden Schichten bestehen kann. Dem Empfangselement 10 ist eine Mikrolinse 20 (als Bestandteil eines Mikrolinsenarrays) vorgeordnet, welche ein auftreffendes Lichtbündel mit einem Hauptstrahl 18 auf die Fotodiode 14 fokussiert.

Bei der in Fig. 1a dargestellten Situation beträgt der Hauptstrahlwinkel 0°, so dass das Lichtbündel senkrecht auf das Empfangselement 10 auftrifft. In der Fig. 1b dargestellten Situation trifft das Lichtbündel schräg auf den Bildsensor bzw. das Empfangselement 10 auf, d.h. der Hauptstrahlwinkel ist ungleich 0°. Dies führt dazu, dass zumindest ein Teil des Lichtbündels nicht mehr auf die Fotodiode 14 trifft, sondern seitlich auf die Abschirmung 16 und von dieser zum Großteil absorbiert wird. Durch diesen Lichtverlust wird die Lichtempfindlichkeit des Bildsensors erheblich reduziert.

Zur Vermeidung des in Fig. 1b dargestellten Effekts ist es bekannt, die Mikrolinsen 20 bzw. das Mikrolinsenarray lateral, d.h. parallel zur Oberfläche des Bildsensors, zu verschieben. Entsprechende Situationen sind in Fig. 1c und 1d dargestellt. Der Betrag dieser Verschiebung δx und deren Richtung wird entsprechend dem anwendungsspezifisch zu erwartenden Hauptstrahlwinkel so gewählt, dass der Hauptstrahl 18 möglichst in der Mitte der Fotodiode 14 auftrifft, so dass eine möglichst hohe Lichtausbeute erhalten wird.

Bei derartigen herkömmlichen Bildsensoranordnungen mit versetztem Mikrolinsenarray ist in der Regel jedoch ein fester Versatz δx vorgegeben, so dass diese Bildsensoranordnungen nur für einen bestimmten Hauptstrahlwinkel bzw. für eine bestimmte Lichteinfallsrichtung optimiert sind. Grundsätzlich ist es jedoch möglich, das Mikrolinsenarray relativ zu dem Bildsensor in eine oder zwei Richtungen verschiebbar anzuordnen. Hierdurch kann eine Anpassung an unterschiedliche Einfallswinkel bzw. Einfallsrichtungen des auftreffenden Lichtbündels erfolgen. Hierfür ist jedoch ein nicht unerheblicher konstruktiver und fertigungstechnischer Aufwand erforderlich.

In US 2021/0111211 A1 ist eine gattungsgemäße Bildsensoranordnung beschrieben, bei welcher die Mikrolinsen eines einem Bildsensor vorgeordneten Mikrolinsenarrays in Abhängigkeit von ihrer Lateralposition innerhalb des Arrays einen unterschiedlichen Versatz bezogen auf eine zentrale Relativposition zu einem zugeordneten Empfangselement aufweisen.

In US 7 256 943 B1 ist eine Linse oder ein Mikrolinsenarray mit einer flüssigkeitsgefüllten Kammer beschrieben, die mittels einer elastischen Membran verschlossen und mit einer Polymerflüssigkeit gefüllt ist. Der Fokus der Linse beziehungsweise des Mikrolinsenarrays kann durch Druckänderungen in der Kammer variiert werden.

Aus US 2022/078318 A1 sind Multi-Kamera-Systeme bekannt, bei denen verschiedene Kameras, beispielsweise 2D-Kameras mit unterschiedlichen Bildwinkeln oder mit unterschiedlicher Funktionalität zum Einsatz gelangen. Ein beispielhaftes Multi-Kamera-System umfasst eine Hauptlinse und zwei Pixelarrays, die auf einem gemeinsamen Sensorchip angeordnet sind. Den Pixelarrays sind jeweilige Mikrolinsenarrays zugeordnet. Mit Hilfe einer der Hauptlinse nachgeordneten Metalinse wird das durch die Hauptlinse einfallende Licht wellenlängenabhängig umgelenkt, wobei sichtbares Licht auf das als RGB-Array ausgebildete eine Pixelarray und infrarotes Licht auf das als SPAD/APD-Array ausgebildete andere Pixelarray gelenkt wird.

US 2023/0319384 A1 beschreibt ein metaoptisches Gerät, das eine Metalinse mit einer Vielzahl von Nanostrukturen, einen Bandpassfilter, der Licht vorgegebener Wellenlängen innerhalb eines Betriebswellenlängenbands der Metalinse durchlässt, und eine Abstandsschicht zwischen der Metalinse und dem Bandpassfilter umfasst, um die Vielzahl von Nanostrukturen zu stützen und einen Abstand zwischen der Metalinse und dem Bandpassfilter zu schaffen.

US 2007/0285843 A1 betrifft Systeme und Verfahren zur Herstellung einer elektronischen Vorrichtung auf einem Substrat. Dazu werden erste, zweite, dritte und vierte Viren gentechnisch verändert, die jeweils eine Vielzahl selektiver Bindungsstellen aufweisen. Die ersten, zweiten, dritten und vierten viralen Biotemplates werden durch Eintauchen der ersten, zweiten, dritten und vierten Viren in eine oder mehrere Lösungen mit Nanomaterialien gebildet, die an die Bindungsstellen der Viren koppelbar sind. Ein Gate wird mit dem ersten viralen Biotemplate selbstorganisiert, wobei eine Stelle am Substrat anbringbar ist. Eine Quelle wird über dem Gate mit dem zweiten viralen Biotemplate selbstorganisiert. Ein Kanal wird mit dem dritten viralen Biotemplate selbstorganisiert, wobei eine Stelle am zweiten viralen Biotemplate anbringbar ist. Und ein Drain wird mit dem vierten viralen Biotemplate selbstorganisiert, wobei eine Stelle am dritten viralen Biotemplate anbringbar ist.

Es ist die Aufgabe der vorliegenden Erfindung, eine Bildsensoranordnung der eingangs genannten Art zu schaffen, bei welcher zur Optimierung der Lichtausbeute auf einfache und kostengünstige Weise eine Anpassung an unterschiedliche Lichteintrittswinkel und/oder -richtungen vorgesehen ist.

Die Lösung der Aufgabe erfolgt durch eine Bildsensoranordnung mit den Merkmalen des Anspruchs 1. Erfindungsgemäß ist vorgesehen, dass das Mikrolinsenarray als ein Metaoptikarray mit einer Matrixanordnung von aktiven Metaoptiken ausgebildet ist, wobei die aktiven Metaoptiken eingerichtet sind, in Ansprechen auf ein zugeführtes Steuersignal zumindest eine ihrer optischen Eigenschaften zu verändern.

Bei den genannten Metaoptiken handelt es sich um vergleichsweise neue optische Elemente, welche ihre optischen Eigenschaften unter der Einwirkung von externen Signalen verändern können. Diese externen Signale oder Steuersignale können beispielsweise in Form von veränderbaren elektrischen Feldern oder Spannungen oder veränderbaren Magnetfeldern erzeugt werden. Des Weiteren können auch optische, thermische oder mechanische Steuersignale eine oder mehrere optische Eigenschaften einer angesteuerten Metaoptik verändern. Beispielhafte Metaoptiken können beispielsweise ein aus einer Vielzahl von sogenannten Nanoantennen bestehendes Array umfassen, wobei jede Nanoantenne einem durch sie hindurchtretenden Lichtstrahl eine entsprechende Phasenverschiebung hinzufügt. Die auf die Nanoantennen einwirkenden Steuersignale können beispielsweise eine Änderung der Dicke der Nanoantennen bewirken, wobei die Phasenverschiebung von der Dicke der Nanoantenne abhängt. Die Abstände der einzelnen Nanoantennen in einem derartigen Nanoantennen-Array sind in der Regel kleiner als die verwendeten Lichtwellenlängen. Die Nanoantennen werden unter Einbeziehung von reaktionsfähigen Materialien wie Halbleitern, Flüssigkristallen und phasenwechselnden Materialien hergestellt. Andere Bauformen von Metaoptiken basieren auf mikroelektromechanischen Systemen (MEMS). Die anzuwendenden Stimuli aktiver Metamaterialien können z.B. elektronisch, optisch, mechanisch, thermisch und/oder magnetisch sein. Durch entsprechende Inhomogenitäten in den zur Ansteuerung der Nanoantennen erzeugten Steuersignalen können die Phasenverschiebungen, die durch die in den Metaoptiken vorhandenen Nano- oder Mikrostrukturen bewirkt werden, in lateraler Richtung variieren. Die Erzeugung entsprechender inhomogener Steuersignale kann beispielsweise durch ein Erzeugen von inhomogenen elektrischen oder magnetischen Feldern, Temperaturgradienten, Beleuchtungsgradienten oder mechanischen Spannungsgradienten erfolgen.

Die vorstehende Beschreibung der physikalischen Grundlagen ist nur rein beispielhaft und schematisch. Es versteht sich, dass die Art der verwendeten Steuersignale von den für die Metaoptiken verwendeten Technologien, den eingesetzten Materialien und deren Strukturierung abhängt.

Auch wenn hier zum besseren Verständnis auf zweidimensionale Bildsensoren bzw. Bildsensoranordnungen Bezug genommen wird, beziehen sich die erfindungsgemäßen Matrixanordnungen auch auf eine (eindimensionale) 1xn-Matrix mit n > 1, d.h. beispielsweise auf einen Zeilensensor mit einer vorgeordneten Mikrolinsen- bzw. Metaoptikzeile.

Gemäß einer bevorzugten Ausführungsform umfasst die zumindest eine der optischen Eigenschaften eine laterale Relativposition eines optischen Mittelpunkts einer jeweiligen Metaoptik bezogen auf das zugeordnete Empfangselement. Mit anderen Worten kann durch Zuführung entsprechender Steuersignale der optische Mittelpunkt einer jeweiligen Metaoptik des Metaoptikarrays lateral, d.h. parallel zur Haupterstreckungsebene des Bildsensors, verschoben werden. Unter dem optischen Mittelpunkt einer Metaoptik wird insbesondere derjenige Bereich einer Metaoptik verstanden, den ein einfallender Lichtstrahl ohne Richtungsänderung passiert. Somit kann der optische Mittelpunkt der Metaoptik auch als der Schnittpunkt des Hauptstrahls eines einfallenden Lichtbündels mit der Hauptebene der Metaoptik verstanden werden. Es erfolgt hierbei keine mechanische Lateralverschiebung der Metaoptik bzw. des Metaoptikarrays, sondern die physikalischen Eigenschaften einer jeweiligen Metaoptik werden durch die Steuersignale so beeinflusst, dass sich eine gewünschte Verschiebung des (optischen) Linsenmittelpunkts einstellt. Beispielsweise kann eine von einer Metaoptik verursachte Phasenverschiebung im Bereich des Metaoptik-Mittelpunkts ein Maximum aufweisen und radial zu den Rändern hin abnehmen. Durch diesen "Phasenverschiebungsgradienten" kann die Metaoptik eine einer Sammellinse entsprechende Brechung oder auch eine Diffraktion des einfallenden Lichts bewirken. In Ansprechen auf zugeführte Steuersignale kann der Ort der maximalen Phasenverschiebung lateral verschoben werden.

Insbesondere kann eine Zentrierung der durch die einzelnen Metaoptiken des Metaoptikarrays verlaufenden Hauptstrahlen auf die jeweils zugeordneten Empfangselemente durch eine geeignete Anpassung, zum Beispiel eine Verringerung, des effektiven Rastermaßes des Metaoptikarrays in Zeilen- und/oder Spaltenrichtung bewirkt werden, wobei sich das effektive Rastermaß auf die eingestellten optischen Mittelpunkte des Metaoptikarrays bezieht. Eine solche Anpassung, insbesondere eine Verringerung, des effektiven Rastermaßes des Metaoptikarrays, kann insbesondere dann besonders vorteilhaft sein, wenn das Metaoptikarray gemäß einer noch zu beschreibenden Ausgestaltung beabstandet von einer Empfangsfläche des Bildsensors (beziehungsweise der Zeilen- oder Arrayanordnung der Empfangselemente des Bildsensors) angeordnet ist.

Grundsätzlich können durch eine entsprechende Ausgestaltung des Steuersignals bzw. der Steuersignale auch andere optische Eigenschaften der Metaoptik bzw. des Metaoptikarrays verändert werden, beispielsweise die Brennweite oder die Absorption aller oder einzelner Metaoptiken.

Gemäß einer bevorzugten Ausführungsform ist ein Verändern der lateralen Relativposition entlang einer Zeilenrichtung und/oder einer Spaltenrichtung des Metaoptikarrays vorgesehen. Unter der Zeilenrichtung bzw. der Spaltenrichtung wird eine Verlaufsrichtung der Zeilen bzw. der Spalten des Metaoptikarrays verstanden. Während bei einer Veränderung der lateralen Relativposition nur entlang einer Zeilenrichtung oder nur entlang einer Spaltenrichtung nur eine Anpassung der Bildsensoranordnung auf Variationen des Hauptstrahlwinkels in einer bestimmten Richtung erfolgen kann, erlaubt ein Verändern der lateralen Relativposition sowohl in Zeilenrichtung als auch in Spaltenrichtung auch eine Anpassung an unterschiedliche Einfallsrichtungen des beaufschlagenden Lichtbündels.

Gemäß einer weiteren bevorzugten Ausführungsform ist das Metaoptikarray in einer vertikalen Richtung beabstandet von einer Empfangsfläche des Bildsensors angeordnet. Der Abstand wird hierbei vorteilhafterweise so gewählt, dass die Brennweiten der Metaoptiken, die zu erwartenden Variationen des Hauptstrahlwinkels und auch möglicherweise Beschränkungen der maximal möglichen Verschiebungen der optischen Mittelpunkte der Metaoptiken berücksichtigt werden. Dementsprechend kann der Abstand z.B. im µm- bis mm-Bereich liegen. Wenn das Metaoptikarray beabstandet von der Empfangsfläche des Bildsensors (beziehungsweise der Zeilen- oder Arrayanordnung der Empfangselemente des Bildsensors) angeordnet ist, kann dabei zur Zentrierung der Hauptstrahlen der einzelnen Metaoptiken bezüglich der jeweiligen Empfangselemente des Bildsensors eine Anpassung, insbesondere eine Verringerung, des effektiven Rastermaßes des Metaoptikarrays in Zeilen- und/oder Spaltenrichtung besonders vorteilhaft wirken.

Gemäß einer weiteren vorteilhaften Ausführungsform sind die aktiven Metaoptiken dazu eingerichtet, in Ansprechen auf die Steuersignale die zumindest eine ihrer optischen Eigenschaften in Abhängigkeit von der Position einer jeweiligen Metaoptik innerhalb der Matrixanordnung in einem unterschiedlichen Maß zu verändern. Beispielsweise kann eine Signalstärke des externen Signals über die Fläche des Metaoptikarrays variieren und entsprechend der Lateralposition der beeinflussten Metaoptik deren optische Eigenschaft in unterschiedlichem Maß verändern. Bezogen auf eine der vorstehend genannten Ausführungsformen kann dies beispielsweise bedeuten, dass das Ausmaß einer Verschiebung der lateralen Relativposition des optischen Mittelpunkts einer jeweiligen Metaoptik von deren Position innerhalb des Metaoptikarrays abhängt.

In einem Anwendungsbeispiel kann die Verschiebung der Lateralposition in der Mitte der Bildsensoranordnung gleich Null sein und mit zunehmendem Abstand von der Mitte zu den Rändern der Bildsensoranordnung hin zunehmen, wobei die Richtung der Lateralverschiebung radial zur Mitte des Bildsensors hin ausgerichtet ist. Hierdurch kann erreicht werden, dass Randbereiche einer aufzunehmenden Szene mit der gleichen Helligkeit erfasst werden wie deren Mittenbereiche, obwohl die Hauptstrahlen einer der Bildsensoranordnung vorgeordneten bilderzeugenden Abbildungslinse für Randbereiche der abzubildenden Szene unter einem flacheren Winkel auf die Bildsensoranordnung treffen, als dies für Mittenbereiche der abzubildenden Szene der Fall ist.

Grundsätzlich kann das Maß der Verschiebung der lateralen Relativpositionen anstelle des vorstehend beschriebenen radialen Gradienten auch einen unidirektionalen Gradienten über die Erstreckung des Metaoptikarrays aufweisen. Beispielsweise kann das Maß der lateralen Verschiebung an einem Rand des Metaoptikarrays kleiner sein als an dem gegenüberliegenden Rand. Eine derartige Ausgestaltung hat sich insbesondere für die Anwendung der erfindungsgemäßen Bildsensoranordnung in Abbildungssystemen als nützlich erwiesen, welche gemäß der Scheimpflug-Bedingung konfiguriert sind. Bei einem solchen Abbildungssystem verläuft die Bildebene, in welcher die erfindungsgemäße Bildsensoranordnung vorgesehen ist, geneigt zu einer Hauptebene einer Abbildungslinse des Abbildungssystems. Dabei ergeben sich schräge Einfallswinkel der von der Bildsensoranordnung zu erfassenden Lichtstrahlen, gegebenenfalls auch unterschiedliche Einfallswinkel, welche durch eine entsprechende Ansteuerung des Metaoptikarrays wie beschrieben kompensiert werden können.

Ein weiteres Anwendungsgebiet für eine erfindungsgemäße Bildsensoranordnung besteht in der Verwendung in einem Abbildungssystem, bei dem ein sogenannter Fokusspiegel zur Anwendung kommt. Bei einem solchen Abbildungssystem erfolgt eine Nachfokussierung bei sich ändernden Objektweiten nicht durch eine Veränderung der Relativposition zwischen einer Abbildungslinse und der Bildsensoranordnung, sondern durch ein kombiniertes Verschieben und Verschwenken eines sogenannten Fokusspiegels, wodurch die Bildweite verändert werden kann. Durch das Verschieben und Verschwenken des Fokusspiegels verändert sich bei einer derartigen Anordnung der Einfallswinkel auf die Bildsensoranordnung. Diese Änderung des Einfallswinkels kann durch eine entsprechende Ansteuerung des Metaoptikarrays kompensiert werden. Hierfür kann beispielsweise eine Steuerung vorgesehen werden, bei welcher die Steuersignale für das Metaoptikarray auf der Grundlage der Verstellposition des Fokusspiegels erzeugt wird.

Sofern Metaoptiken eine Polarisationsempfindlichkeit aufweisen, kann diese genutzt werden, um das einfallende Licht nach dem Polarisationszustand zu diskriminieren. Dieser zusätzliche Diskriminator kann auch dynamisch umgeschaltet werden, beispielsweise zwischen den Zuständen "unpolarisiert", "linear polarisiert" und/oder "links/rechts zirkular polarisiert".

Grundsätzlich ist bei allen hier beschriebenen und weiteren denkbaren Ausführungsformen und Anwendungsfällen nicht nur eine statische Anpassung an vorgegebene Empfangsverhältnisse möglich, sondern es kann auch eine dynamische Anpassung der optischen Eigenschaften des Metaoptikarrays erfolgen.

Sowohl für statische als auch dynamische Anpassungen kann die Bildsensoranordnung beispielsweise mit einer entsprechenden Auswerte- und Steuereinheit verbunden werden, welche die dem Metaoptikarray zugeführten Steuersignale in Abhängigkeit von einem gemessenen Einfallswinkel der zu erfassenden Lichtsignale erzeugt. Hier kann die Steuer- und Auswerteeinheit mit einer geeigneten Messvorrichtung verbunden sein. Eine solche Messvorrichtung kann den Einfallswinkel beispielsweise nach dem Triangulationsprinzip mit Hilfe eines optischen Positionssensors, beispielsweise einer Fotodiodenanordnung mit zwei oder mehr Sektoren und einer vorgeordneten Linse umfassen. Bei einer solchen Messvorrichtung wird auf dem optischen Positionssensor ein Lichtfleck erzeugt, dessen Position vom Einfallswinkel des erfassten Lichtbündels abhängt und beispielsweise durch Differenzbildung der von den verschiedenen Sektoren erfassten jeweiligen Lichtmengen ermittelt werden kann. In der Steuer- und Auswerteeinheit kann demnach eine Steuerung oder Regelung implementiert sein, welche das Steuersignal bzw. die Steuersignale statisch oder dynamisch in Abhängigkeit von dem ermittelten Einfallswinkel erzeugt.

Alternativ oder zusätzlich kann auch die Position einer der Bildsensoranordnung vorgeordneten Abbildungslinse (Lateralposition und/oder Abstand zur Bildsensoranordnung) mittels eines geeigneten Positionssensors ermittelt und zur Erzeugung der Steuersignale für das Metaoptikarray verwendet werden.

Alternativ oder zusätzlich kann auch der Typ oder die Bauart einer der Bildsensoranordnung vorgeordneten Abbildungslinse auf der Grundlage eines an der Abbildungslinse angeordneten Identifikationscodes, z.B. in Form eines RFID-Tags oder eines optischen Codes, ermittelt werden. Hieraus können dann die für die Ansteuerung des Metaoptikarrays maßgeblichen optischen bzw. geometrischen Linsenparameter und insbesondere auch der sich daraus ergebende Hauptstrahlwinkel ermittelt werden und zur Erzeugung der Steuersignale für das Metaoptikarray verwendet werden. Diese Parameter können in dem Identifikationscode unmittelbar codiert sein oder mittelbar über eine Nachschlagtabelle ermittelt werden.

Eine zur Erzeugung der Steuersignale für das Metaoptikarray notwendige Parametrierung der von der Steuer- und Auswerteeinheit verwendeten Steuerungsalgorithmen, die insbesondere vorstehend genannte anwendungsspezifisch ermittelte Einfallswinkel, Positionsdaten und/oder Linsenparameter einschließen kann, kann sowohl bereits während des Herstellungsprozesses erfolgen oder vom Anwender der Bildsensoranordnung selbst durchgeführt werden.

Vorteilhafte Weiterbildungen der Erfindung sind auch in den abhängigen Ansprüchen, der Beschreibung sowie den Zeichnungen angegeben. Die Ansprüche, die Beschreibung und die Zeichnungen enthalten zahlreiche Merkmale in Kombination. Der Fachmann wird diese Merkmale zweckmäßigerweise auch einzeln betrachten und zu sinnvollen weiteren Kombinationen zusammenfassen.

Die Erfindung wird nachfolgend beispielhaft anhand von Zeichnungen beschrieben. Die Darstellungen in den Figuren sind als nicht maßstabsgetreu zu verstehen.

Es zeigen:
- Fig. 1: eine schematische Ansicht eines Teils einer Bildsensoranordnung gemäß dem Stand der Technik; und
- Fig. 2: eine schematische Ansicht eines Teils einer Bildsensoranordnung gemäß einem Ausführungsbeispiel.

Fig. 2 zeigt eine Bildsensoranordnung gemäß einem Ausführungsbeispiel, wobei die Teilfiguren 2a bis 2d jeweils zu den vorstehend bereits beschriebenen Teilfiguren 1a bis 1d korrespondieren. In Fig. 2 ist wie auch in Fig. 1 jeweils nur ein einziges Empfangselement 10 der Bildsensoranordnung dargestellt. Beim Ausführungsbeispiel gemäß Fig. 2 ist anstelle einer Mikrolinse 20 (Fig. 1) eine aktive Metaoptik 30 vorgesehen, welche als Sammellinse wirkt und ein einfallendes Lichtbündel auf die Fotodiode 14 bündelt. Die aktive Metaoptik 30 kann in Ansprechen auf ein zugeführtes Steuersignal zumindest eine ihrer optischen Eigenschaften verändern. Die genannten optischen Eigenschaften umfassen beim Ausführungsbeispiel gemäß Fig. 2 eine laterale Relativposition des optischen Mittelpunkts der Metaoptik 30. Mit anderen Worten kann durch Zuführen eines entsprechenden Steuersignals der optische Mittelpunkt der Metaoptik 30 in lateraler Richtung verschoben werden. Da durch das Steuersignal intrinsische Eigenschaften der Metaoptik 30 verändert werden, ist dies in der Abbildung von Fig. 2 lediglich durch den hierdurch verursachten Effekt erkennbar.

Fig. 2a zeigt korrespondierend zuFig. 1aeine Situation, bei welcher der Hauptstrahlwinkel 0° beträgt und der Hauptstrahl 18 mittig auf die Fotodiode 14 trifft.

Fig. 2b zeigt korrespondierend zu Fig. 1b eine Situation, bei welcher der Hauptstrahlwinkel von 0° abweicht, jedoch noch keine Verschiebung des Linsenmittelpunks der Metaoptik 30 erfolgt ist. Ein Teil des Lichtbündels trifft nicht auf die Fotodiode 14, sondern auf die Abschirmung 16 und wird dort absorbiert oder gestreut.

Fig. 2c zeigt korrespondierend zu Fig. 1c den Fall, dass der wirksame optische Mittelpunkt der Metaoptik 30 in Ansprechen auf ein entsprechendes Steuersignal um einen Betrag δx verschoben ist, so dass der schräg einfallende Hauptstrahl 18 (im gleichen Winkel wie in Fig. 2b) nunmehr ungefähr in der Mitte der Fotodiode 14 auftrifft, so dass das Lichtbündel vollständig von der Fotodiode 14 erfasst wird..

Fig. 2d zeigt eine Situation, bei welcher der Hauptstrahl 18 im Vergleich zu der Situation von Fig. 2c aus einer entgegengesetzten Richtung auf das Empfangselement 10 auftrifft. Dementsprechend wird der wirksame optische Mittelpunkt der Metaoptik 30 um den gleichen Betrag δx, jedoch mit entgegengesetztem Vorzeichen verschoben, so dass der Hauptstrahl 18 auch hier annähernd mittig auf die Fotodiode 14 trifft.

### Bezugszeichenliste

- 10: Empfangselement
- 12: Substrat
- 14: Fotodiode
- 16: Abschirmung
- 18: Hauptstrahl
- 20: Mikrolinse
- 30: Metaoptik

## Patentansprüche

1. Bildsensoranordnung,
mit einem Bildsensor, welcher eine Matrixanordnung von lichtempfindlichen Empfangselementen (10) aufweist, und
mit einem dem Bildsensor vorgeordneten Mikrolinsenarray mit einer Matrixanordnung von Mikrolinsen (20), wobei einem jeweiligen Empfangselement (10) eine jeweilige Mikrolinse (20) zugeordnet ist,
**dadurch gekennzeichnet,**
**dass** das Mikrolinsenarray als ein Metaoptikarray mit einer Matrixanordnung von aktiven Metaoptiken (30) ausgebildet ist, wobei die aktiven Metaoptiken (30) eingerichtet sind, in Ansprechen auf ein zugeführtes Steuersignal zumindest eine ihrer optischen Eigenschaften zu verändern.

2. Bildsensoranordnung nach Anspruch 1,
**dadurch gekennzeichnet,**
**dass** die zumindest eine der optischen Eigenschaften eine laterale Relativposition eines optischen Mittelpunkts einer jeweiligen Metaoptik (30) bezogen auf das zugeordnete Empfangselement (10) umfasst.

3. Bildsensoranordnung nach Anspruch 2,
**dadurch gekennzeichnet,**
**dass** ein Verändern der lateralen Relativposition entlang einer Zeilenrichtung und/oder einer Spaltenrichtung des Metaoptikarrays vorgesehen ist.

4. Bildsensoranordnung nach einem der vorhergehenden Ansprüche,
**dadurch gekennzeichnet,**
**dass** das Metaoptikarray in einer vertikalen Richtung beabstandet von einer Empfangsfläche des Bildsensors angeordnet ist.

5. Bildsensoranordnung nach einem der vorhergehenden Ansprüche,
**dadurch gekennzeichnet,**
**dass** die aktiven Metaoptiken (30) dazu eingerichtet sind, in Ansprechen auf das Steuersignal die zumindest eine ihrer optischen Eigenschaften in Abhängigkeit von der Position einer jeweiligen Metaoptik (30) innerhalb der Matrixanordnung in einem unterschiedlichen Maß zu verändern.

## Claims

1. An image sensor arrangement, comprising
an image sensor, which has a matrix arrangement of light-sensitive receiving elements (10), and
a microlens array which is arranged in front of the image sensor and which comprises a matrix arrangement of microlenses (20), wherein a respective receiving element (10) is assigned a respective microlens (20), **characterized in that**
the microlens array is configured as a meta-optics array comprising a matrix arrangement of active meta-optics (30), with the active meta-optics (30) being configured to change at least one of their optical properties in response to a supplied control signal.

2. An image sensor arrangement according to claim 1,
**characterized in that**
the at least one of the optical properties comprises a lateral relative position of an optical center of a respective meta-optics (30) with respect to the associated receiving element (10).

3. An image sensor arrangement according to claim 2,
**characterized in that**
a change of the lateral relative position along a row direction and/or a column direction of the meta-optics array is provided.

4. An image sensor arrangement according to any one of the preceding claims,
**characterized in that**
the meta-optics array is arranged spaced apart from a receiving surface of the image sensor in a vertical direction.

5. An image sensor arrangement according to any one of the preceding claims,
**characterized in that**
the active meta-optics (30) are configured, in response to the control signal, to change the at least one of their optical properties to a different extent in dependence on the position of a respective meta-optics (30) within the matrix arrangement.

## Revendications

1. Ensemble de capteur d'image,
comprenant un capteur d'image qui présente un agencement matriciel d'éléments récepteurs photosensibles (10), et
un réseau de microlentilles disposé en amont du capteur d'image et comportant un agencement matriciel de microlentilles (20), une microlentille (20) respective étant associée à un élément récepteur (10) respectif, **caractérisé en ce que** le réseau de microlentilles est conçu comme un réseau de méta-optiques comportant un agencement matriciel de méta-optiques actives (30), les méta-optiques actives (30) étant agencées pour modifier au moins l'une de leurs propriétés optiques en réponse à un signal de commande appliqué.

2. Ensemble de capteur d'image selon la revendication 1,
**caractérisé en ce**
**que** ladite au moins une des propriétés optiques comprend une position relative latérale d'un centre optique d'une méta-optique respective (30) par rapport à l'élément récepteur associé (10).

3. Ensemble de capteur d'image selon la revendication 2,
**caractérisé en ce**
**qu'**une modification de la position relative latérale est prévue le long d'une direction de ligne et/ou d'une direction de colonne du réseau de méta-optiques.

4. Ensemble de capteur d'image selon l'une des revendications précédentes,
**caractérisé en ce**
**que** le réseau de méta-optiques est disposé dans une direction verticale espacé d'une surface de réception du capteur d'image.

5. Ensemble de capteur d'image selon l'une des revendications précédentes,
**caractérisé en ce**
**que** les méta-optiques actives (30) sont agencées pour modifier, en réponse au signal de commande, au moins l'une de leurs propriétés optiques dans une mesure différente en fonction de la position d'une méta-optique respective (30) au sein de l'agencement matriciel.
